# EUROPEAN PATENT APPLICATION

(11) **EP 3 878 596 A1**
(43) Date of publication of application: **15.09.2021**
(21) Application number: 19882815.4
(22) Date of filing: 05.11.2019
(51) Int. Cl.: B23K 35/363, H05K 3/34, B23K 35/26, C22C 13/00

(54) **FLUX, METHOD FOR APPLYING FLUX, AND METHOD FOR MOUNTING SOLDER BALL**

(30) Priority: 06.11.2018 JP 2018208657
(71) Applicant: Senju Metal Industry Co., Ltd., Tokyo 120-8555 (JP)
(72) Inventor: NISHIZAKI Takahiro, Tokyo 120-8555 (JP); FUKUYAMA Naoaki, Tokyo 120-8555 (JP); KAWASAKI Hiroyoshi, Tokyo 120-8555 (JP)
(74) Representative: Lavoix
(86) International application number: PCT/JP2019/043279
(87) International publication number: WO 2020/095892

(57) **Abstract**

Provided is flux that can be discharged using an inkjet method and that is capable of bonding to an adherend after application. This flux includes 5-50 mass% of a solid solvent having a melting point of 60°C or less, 50-80 mass% of a solvent, 5-10 mass% of an organic acid, 10-30 mass% of an amine, and 0-5 mass% of a halide, the flux forming a liquid having a high viscosity of 5 Pa·s or higher at 25°C, and forming a liquid having a low viscosity of 50 mPa·s or less at 100°C.

## Description

### Technical Field

The present invention relates to a flux that can be applied through an ink-jet method, a method for applying this flux, and a method for mounting a solder ball in which this flux is used.

### Background Art

In general, a flux used for soldering has an effect of chemically removing metal oxides present on surfaces of a solder alloy and metal, which is a joining object to be soldered, and enabling movement of metallic elements at the boundary between the two surfaces. For this reason, an intermetallic compound can be formed between the surfaces of the solder alloy and the metal which is a joining object by performing soldering using the flux, thereby attaining firm joining.

In known technology in which a solder bump is formed using spherical solder called a solder ball, a flux is applied to an electrode of a substrate, and the solder ball is placed on the electrode, on which the flux is applied, and heated in a reflow furnace to form a solder bump on the electrode of the substrate.

With the progression of miniaturization of electronic components in recent years, micronization of a wiring pattern of a substrate, narrowing of pitches of a formed solder bump, and formation of a small solder bump have been required.

A technology of using an ink-jet method as a method for applying a flux has been proposed (for example, refer to Patent Literature 1).

### Citation List

### Patent Literature

[Patent Literature 1] Japanese Unexamined Patent Application, First Publication No. 2009-253088

### Summary of Invention

### Technical Problem

In order to discharge a flux through an ink-jet method, it is necessary to set the viscosity of the flux to be less than or equal to 50 mPa·s. Since viscosity is a physical property indicating the degree of adhesiveness, if the viscosity is low, the adhesiveness of a flux naturally deteriorates. As a result, the flux that can be discharged through the ink-jet method does not have a force for holding a mounted object such as a solder ball and cannot prevent positional displacement of the mounted object.

By heating a flux to a temperature higher than or equal to a melting point, the flux becomes a low-viscosity liquid and can be discharged through an ink-jet method. In addition, by lowering the temperature of the flux after application through the ink-jet method, the viscosity of the flux increases.

However, in the related art, although the viscosity of a flux that can be discharged through an ink-jet method increases due to lowering of the temperature of the flux after application through the discharge, the flux flows from the application site over time. For this reason, in a case where a solder ball is placed on a flux applied to an electrode, the flux may flow. Therefore, there is a possibility of the solder ball not being able to be fixed at a predetermined position. In addition, in a case where a substrate is cooled using a cooling mechanism as in Patent Literature 1 to lower the temperature of a flux, there is a possibility that dew condensation may occur.

The present invention has been made in order to solve such problems, and an object of the present invention is to provide a flux which can be discharged through an ink-jet method and to which an object can be fixed after application, a method for applying this flux, and a method for mounting a solder ball using this flux.

### Solution to Problem

It is known that, by adding a solid solvent which becomes a high-viscosity liquid in a normal temperature range of 15°C to 35°C and a solvent which dissolves the solid solvent to a flux, the flux can be discharged through an ink-jet method since the flux becomes a low-viscosity liquid in a temperature range exceeding a melting point, and an object such as a solder ball can be fixed thereto in a normal temperature range.

The high-viscosity liquid has a high viscosity in view of the viscosity with which a liquid can be discharged through an ink-jet method, and this refers to a state in which solid matter and a liquid are mixed with each other.

The present invention is a flux which contains 5 mass% to 50 mass% of a solid solvent having a melting point of 35°C to 60°C, 50 mass% to 80 mass% of a solvent, 5 mass% to 10 mass% of an organic acid, 10 mass% to 30 mass% of an amine, and 0 mass% to 5 mass% of a halide, in which the flux becomes a liquid having a high viscosity of greater than or equal to 5 Pa·s at 25°C and becomes a liquid having a low viscosity of less than or equal to 50 mPa·s at 100°C.

In addition, the present invention is a method for applying a flux, the method including: heating the flux to a temperature of 75°C to 100°C and discharging the flux through an ink-jet method to apply the flux to an electrode of a substrate, in which the flux used contains 5 mass% to 50 mass% of a solid solvent having a melting point of 35°C to 60°C, 50 mass% to 80 mass% of a solvent, 5 mass% to 10 mass% of an organic acid, 10 mass% to 30 mass% of an amine, and 0 mass% to 5 mass% of a halide, and the flux becomes a liquid having a high viscosity of greater than or equal to 5 Pa·s at 25°C and becomes a liquid having a low viscosity of less than or equal to 50 mPa·s at 100°C.

Furthermore, the present invention is a method for mounting a solder ball, the method including: heating a flux to a temperature of 75°C to 100°C and discharging the flux through an ink-jet method to apply the flux to an electrode of a substrate; and placing a solder ball on the flux applied to the electrode of the substrate and of which the temperature decreases to below 35°C to fix the solder ball with the flux, in which the flux used contains 5 mass% to 50 mass% of a solid solvent having a melting point of 35°C to 60°C, 50 mass% to 80 mass% of a solvent, 5 mass% to 10 mass% of an organic acid, 10 mass% to 30 mass% of an amine, and 0 mass% to 5 mass% of a halide, and the flux becomes a liquid having a high viscosity of greater than or equal to 5 Pa·s at 25°C and becomes a liquid having a low viscosity of less than or equal to 50 mPa·s at 100°C.

The diameter of the electrode is greater than 0 µm and less than or equal to 1,000 µm in a case where the electrode is circular, and the length of the electrode in a short direction is greater than 0 µm and less than or equal to 1,000 µm in a case where the electrode is quadrilateral. It is preferable that the diameter of the electrode be 30 µm to 100 µm in a case where the electrode is circular, and that the length of the electrode in a short direction be 30 µm to 100 µm in a case where the electrode is quadrilateral.

In addition, the diameter of the solder ball is 1 µm to 1,000 µm. It is more preferable that the diameter of the solder ball be 30 µm to 100 µm.

The flux of the present invention becomes a liquid having a low viscosity of less than or equal to 50 mPa·s by being heated to a predetermined temperature range of a melting point to 100°C. Accordingly, in the flux of the present invention, the method for applying a flux of the present invention, and the method for mounting a solder ball of the present invention, application of the flux by discharge through an ink-jet method can be performed.

The flux of the present invention becomes a high-viscosity liquid having a viscosity of greater than or equal to 5 Pa·s by lowering the temperature to a normal temperature range of about 15°C to 35°C. Since the flux becomes a liquid having a high viscosity of greater than or equal to 5 Pa·s, the flux is suppressed from flowing from an application site. Accordingly, in the flux of the present invention and the method for mounting a solder ball of the present invention, if an object such as a solder ball is placed on a flux applied to an electrode, the flux does not flow, and the object can be fixed at a predetermined position.

### Advantageous Effects of Invention

In the present invention, application of a flux by discharge through an ink-jet method can be performed. In addition, an object can be fixed using a flux.

### Description of Embodiments

A solid solvent and a solvent are added to a flux of the present embodiment in addition to an activator component. The flux of the present embodiment becomes a high-viscosity liquid to which an object can be fixed in a normal temperature range and becomes a low-viscosity liquid which does not flow out in a normal temperature range and is applicable by discharge in a predetermined temperature range which is higher than the normal temperature range.

For this reason, a solid solvent having a melting point of 35°C to 60°C is added to the flux of the present embodiment. Polyethylene glycol is added as such a solid solvent. The molecular weight of polyethylene glycol preferably has a weight-average molecular weight (MW) of 1,000 to 5,000 which is measured by gel permeation chromatography (GPC) in terms of polyethylene glycol. The added amount of the solid solvent is 5 mass% to 50 mass%.

In addition, a solvent is added to dissolve the solid solvent. In a case where a solvent is volatilized due to heating during discharge of a flux, the viscosity of the flux increases. Therefore, a solvent having a boiling point of higher than or equal to 180°C is used. Any of dipropylene glycol monomethyl ether or methyl propylene diglycol, or a mixture of two or more of these compounds is added to the flux as such a solvent. The added amount of the solvent is 50 mass% to 80 mass%.

An organic acid and an amine are added to the flux of the present embodiment as an activator. Glutaric acid is added as an organic acid. The added amount of the organic acid is 5 mass% to 10 mass%. A propylene oxide (PO) additive of ethylenediamine is added as an amine. The added amount of the amine is 10 mass% to 30 mass%. A halide may be added as an activator. The added amount of the halide is 0 mass% to 5 mass%.

The flux of the present embodiment having such a composition becomes a liquid having a high viscosity of greater than or equal to 5 Pa·s at 25°C. Furthermore, the flux of the present embodiment becomes a liquid having a low viscosity of less than or equal to 50 mPa·s at 100°C.

The flux of the present embodiment preferably becomes a liquid having a low viscosity of less than or equal to 50 mPa·s at 75°C. In addition, the flux of the present embodiment preferably becomes a liquid having a low viscosity of less than or equal to 15 mPa·s at 100°C and more preferably becomes a liquid having a low viscosity of less than or equal to 15 mPa·s at 75°C.

The flux of the present embodiment becomes a liquid having a low viscosity of less than or equal to 50 mPa·s by being heated to a temperature range of 75°C to 100°C. Accordingly, application of the flux by discharge through an ink-jet method can be performed.

An electrode to which a flux is applied is circular or quadrilateral. In a case where the electrode is circular, the electrode to which a flux is applied through an ink-jet method preferably has a diameter of greater than 0 µm and less than or equal to 1,000 µm and more preferably has a diameter of 30 µm to 100 µm. In addition, in a case where the electrode is quadrilateral, the length of the electrode in a short direction is preferably greater than 0 µm and less than or equal to 1,000 µm and more preferably 30 µm to 100 µm.

The flux been applied to a substrate through the ink-jet method becomes a high-viscosity liquid having a viscosity of greater than or equal to 5 Pa·s by lowering the temperature to a normal temperature range of higher than or equal to 15°C and lower than 35°C in a few seconds. Since the flux becomes a liquid having high viscosity of greater than or equal to 5 Pa·s, the flux is suppressed from flowing from an application site. Accordingly, in a case where a solder ball is placed on the flux applied to a substrate, the flux does not flow. Therefore, the solder ball can be fixed at a predetermined position. The diameter of a solder ball is preferably 1 µm to 1,000 µm and more preferably 30 µm to 100 µm.

In the method for applying a flux and the method for mounting a solder ball of the present embodiment, the flux of the present embodiment used contains 5 mass% to 50 mass% of a solid solvent having a melting point of 35°C to 60°C, 50 mass% to 80 mass% of a solvent, 5 mass% to 10 mass% of an organic acid, 10 mass% to 30 mass% of an amine, and 0 mass% to 5 mass% of a halide, in which the flux becomes a liquid having a high viscosity of greater than or equal to 5 Pa·s at 25°C and becomes a liquid having a low viscosity of less than or equal to 50 mPa·s at 100°C.

In the method for applying a flux of the present embodiment, the flux of the present embodiment is heated to a temperature of 75°C to 100°C, discharged through an ink-jet method, and applied to an electrode of a substrate. In the case where the electrode is circular, the diameter of the electrode is preferably greater than 0 µm and less than or equal to 1,000 µm and more preferably 30 µm to 100 µm. In addition, in the case where the electrode is quadrilateral, the length of the electrode in a short direction is preferably greater than 0 µm and less than or equal to 1,000 µm and more preferably 30 µm to 100 µm.

In the method for mounting a solder ball of the present embodiment, the flux of the present embodiment is heated to a temperature of 75°C to 100°C, discharged through an ink-jet method, and applied to an electrode of a substrate, and a solder ball is placed on the flux applied to the electrode of the substrate and of which the temperature decreases to below 35°C, and fixed with the flux. In the case where the electrode is circular, the diameter of the electrode is preferably greater than 0 µm and less than or equal to 1,000 µm and more preferably 30 µm to 100 µm. In addition, in the case where the electrode is quadrilateral, the length of the electrode in a short direction is preferably greater than 0 µm and less than or equal to 1,000 µm and more preferably 30 µm to 100 µm. Furthermore, the diameter of a solder ball is preferably 1 µm to 1,000 µm and more preferably 30 µm to 100 µm.

In the method for applying a flux and the method for mounting a solder ball of the present embodiment, by heating the flux to a temperature range of 75°C to 100°C, the flux becomes a liquid having a low viscosity of less than or equal to 50 mPa·s. Accordingly, the flux can be applied to an electrode of a substrate by discharge through an ink-jet method. In the case where the electrode is circular, the flux is applied to an electrode having a diameter of greater than 0 µm and less than or equal to 1,000 µm. In the case of the ink-jet method, one droplet of a flux of which the size is controlled can be applied to an electrode.

In addition, the flux heated to a temperature range of 75°C to 100°C and applied to a substrate through an ink-jet method becomes a high-viscosity liquid having a viscosity of greater than or equal to 5 Pa·s due to a decrease in temperature to a normal temperature range of about higher than or equal to 15°C and less than 35°C in a few seconds. A solder ball is placed on the flux been applied to the substrate, the flux does not flow, and the solder ball can be fixed at a predetermined position.

### Examples

Fluxes of examples and comparative examples with the compositions shown in the following Table 1 were prepared, and dischargeability through an ink-jet method and fixability after application were verified. The composition ratios in Table 1 are represented by mass% in each flux composition. First, evaluation methods for each verification will be described.

### (1) Verification of Dischargeability through Ink-jet Method

### (A) Test Method

In order to warm a discharge portion of a well-known ink-jet discharge device, a portion was designed through which a passed flux could be heated with a heater. Isopropyl alcohol warmed to about 50°C was passed through the device, a pipe through which the flux would pass was warmed in advance and dried with a drier. The heater started heating during the drying. Immediately after the drying, the melted flux was liquefied in a water bath at about 80°C and discharged to a Cu plate with the ink-jet discharge device. The Cu plate used was a Cu-OSP plate and obtained by subjecting the surface of Cu to an organic solderability preservative (OSP) treatment. Regarding the fluxes of the examples and the comparative examples discharged through the above-described discharging step, the viscosities thereof in a case where the fluxes were heated to 75°C were measured, and the quality of the dischargeability was represented by the viscosities of the fluxes.

A Brookfield type (BIT type) viscometer manufactured by TOKI SANGYO CO., LTD. was used to measure the viscosities at 75°C. The measurement method conforms to JIS Z 3197.

### (B) Determination Criteria

∘: The viscosity at 75°C was less than or equal to 50 mPa·s.
×: The viscosity at 75°C was greater than 50 mPa·s.

### (2) Regarding Verification of Fixability After Application

### (A) Test Method

Regarding the fluxes of the examples and the comparative examples discharged under the same conditions as those in the verification of the dischargeability, the viscosities thereof in a case where the temperatures of the fluxes decreased to 25°C were measured, and the quality of the fixability was represented by the viscosities of the fluxes.

A PCU-205 viscometer manufactured by Malcolm Co., Ltd. was used to measure the viscosities at 25°C. The measurement method conforms to JIS Z 3197. As a test condition, the rotational frequency was 10 rpm.

### (B) Determination Criteria

∘: The viscosity at 25°C was greater than or equal to 5 Pa.s.
×: The viscosity at 25°C was less than 5 Pa·s.

### (3) Regarding Verification of Washability After Application

### (A) Test Method

The fluxes of the examples and the comparative examples were discharged under the same conditions as those in the verification of the dischargeability, and reflowing was performed by applying each flux to an electrode of a substrate. The electrode was circular and had a diameter of 70 µm. In addition, the electrode was a Cu-OSP electrode and obtained by subjecting the surface of Cu to an organic solderability preservative (OSP) treatment. A solder ball was mounted on the electrode to which each flux of the examples and the comparative examples was applied. As the composition of the solder ball, the solder ball contains 3 mass% of Ag, 0.5 mass% of Cu, and a balance of Sn. In addition, the diameter of the solder ball is 65 µm. As the reflow conditions, the temperature was raised from room temperature to 250°C at a temperature rising rate of 1°C/s and held at 250°C for 30 seconds. The substrate after the reflowing was immersed and washed in a washing liquid which had been kept warm at 40°C, and dried. The presence or absence of a flux residue was checked through observation with an optical microscope.

### (B) Determination Criteria

∘: There was no flux residue found.
×: A flux residue was found.

**[Table 1]**

| | | Example 1 | Example 2 | Example 3 | Example 4 | Example 5 | Example 6 | Example 7 | Example 8 | Comparative Example 1 | Comparative Example 2 |
|---|---|---|---|---|---|---|---|---|---|---|---|
| Solid solvent | Polyethylene glycol | 20 | 10 | 50 | 20 | 20 | 20 | 20 | 20 | 0 | 0 |
| Solvent | Dipropylene glycol monomethyl ether | 60 | 50 | 30 | 60 | 45 | 60 | 0 | 30 | 0 | 0 |
| | Diethylene glycol monomethyl ether | 0 | 0 | 0 | 0 | 0 | 0 | 60 | 30 | 80 | 60 |
| Organic acid | Glutaric acid | 5 | 10 | 5 | 10 | 5 | 5 | 5 | 5 | 5 | 5 |
| Amine | PO adduct of ethylenediamine | 15 | 30 | 15 | 10 | 30 | 10 | 15 | 15 | 15 | 15 |
| Halogen | 2,3-Dibromo-1,4-butanediol | 0 | 0 | 0 | 0 | 0 | 5 | 0 | 0 | 0 | 0 |
| Rosin | Rosin ester | 0 | 0 | 0 | 0 | 0 | 0 | 0 | 0 | 0 | 20 |
| Viscosity at 75°C is lower than or equal to 50 mPa·s | | ○ | ○ | ○ | ○ | ○ | ○ | ○ | ○ | ○ | × |
| Viscosity at 25°C is greater than or equal to 5 Pa·s | | ○ | ○ | ○ | ○ | ○ | ○ | ○ | ○ | × | ○ |
| Water washability | | ○ | ○ | ○ | ○ | ○ | ○ | ○ | ○ | ○ | × |

In the fluxes of Examples 1 to 8 containing a predetermined amount of polyethylene glycol as a solid solvent having a melting point of 35°C to 60°C, the viscosity at 75°C was less than or equal to 50 mPa·s, and the fluxes became low-viscosity liquids when being heated to a temperature range of 75°C to 100°C. Accordingly, favorable dischargeability was obtained, and therefore, the fluxes could be discharged through an ink-jet method and could be applied to a substrate.

In addition, in the fluxes of Examples 1 to 8 containing a predetermined amount of polyethylene glycol as a solid solvent, the viscosity at 25°C was greater than or equal to 5 mPa·s, and the fluxes became high-viscosity liquids when the temperature decreased to a normal temperature range. Accordingly, favorable fixability was obtained, and therefore, the positions of the solder balls could be fixed with the fluxes.

Furthermore, in the fluxes of Examples 1 to 8 containing a predetermined amount of polyethylene glycol as a solid solvent, a desired viscosity was obtained without containing rosin. Therefore, favorable washability was obtained, and there was no flux residue found after washing.

The viscosity at 75°C was less than or equal to 50 mPa·s and the dischargeability was favorable even in Examples 2 and 3 in which the content of solid solvent was increased or decreased. In addition, the viscosity at 25°C was greater than or equal to 5 Pa·s, and the fixability was favorable. Furthermore, there was no flux residue found after washing.

The viscosity at 75°C was less than or equal to 50 mPa·s and the dischargeability was favorable even in Examples 4 to 8 in which the contents of solvent, organic acid, amine, and halogen were increased or decreased. In addition, the viscosity at 25°C was greater than or equal to 5 Pa·s, and the fixability was favorable. Furthermore, there was no flux residue found after washing.

In contrast, in the flux of Comparative Example 1 containing no solid solvent, the viscosity at 75°C was less than or equal to 50 mPa·s, but the viscosity at 25°C was less than 5 Pa·s. The flux was a low-viscosity liquid even if the temperature decreased to a normal temperature range. Accordingly, fixability was not obtained, and therefore, the position of a solder ball could not be fixed with the flux when the solder ball was mounted thereon.

In addition, in the flux of Comparative Example 2 containing rosin, but no solid solvent, the viscosity at 25°C was greater than or equal to 5 Pa·s, but the viscosity at 75°C was greater than 50 mPa·s. The flux was a high-viscosity liquid even if the flux was heated to a temperature range of 75°C to 100°C. Accordingly, no dischargeability was obtained, and the flux could not be discharged through an ink-jet method. In addition, washing was not possible because the flux contained rosin.

Even in a case where a predetermined amount of solid solvent having a melting point of lower than 35°C was contained in a flux, the viscosity at 25°C was less than 5 Pa·s, and the flux was a low-viscosity liquid even if the temperature decreased to a normal temperature range. Accordingly, fixability could not be obtained. In addition, even in a case where a predetermined amount of solid solvent having a melting point of greater than 60°C was contained in a flux, the viscosity at 75°C was greater than 50 mPa·s, and the flux was a high-viscosity liquid even if the flux was heated to a temperature range of 75°C to 100°C. Accordingly, dischargeability could not be obtained.

From the above, since a flux containing 5 mass% to 50 mass% of a solid solvent having a melting point of 35°C to 60°C, 50 mass% to 80 mass% of a solvent, 5 mass% to 10 mass% of an organic acid, 10 mass% to 30 mass% of an amine, and 0 mass% to 5 mass% of a halide had a viscosity of less than or equal to 50 mPa·s at 75°C, a low-viscosity liquid at a temperature range of 75°C to 100°C could be obtained. Therefore, it was determined that favorable dischargeability was obtained. Accordingly, the flux could be discharged through an ink-jet method.

In addition, the viscosity at 25°C was greater than or equal to 5 Pa·s, and the flux became a high-viscosity liquid if the temperature decreased to a normal temperature range. Therefore, it was determined that favorable fixability could be obtained. Accordingly, the position of a solder ball could be fixed with the flux.

Furthermore, since the flux contained no rosin, there was no flux residue after washing. Therefore, it was determined that favorable washability could be obtained. Accordingly, the flux can be used for applications requiring washing.

## Claims

1. A flux, comprising:
5 mass% to 50 mass% of a solid solvent having a melting point of 35°C to 60°C;
50 mass% to 80 mass% of a solvent;
5 mass% to 10 mass% of an organic acid;
10 mass% to 30 mass% of an amine; and
0 mass% to 5 mass% of a halide,
wherein the flux becomes a liquid having a high viscosity of greater than or equal to 5 Pa·s at 25°C and becomes a liquid having a low viscosity of less than or equal to 50 mPa·s at 100°C.

2. The flux according to Claim 1,
wherein the flux becomes a liquid having a low viscosity of less than or equal to 50 mPa·s at 75°C.

3. The flux according to Claim 1,
wherein the flux becomes a liquid having a low viscosity of less than or equal to 15 mPa·s at 100°C.

4. The flux according to Claim 1,
wherein the flux becomes a liquid having a low viscosity of less than or equal to 15 mPa·s at 75°C.

5. The flux according to Claim 1,
wherein the solid solvent is polyethylene glycol.

6. The flux according to Claim 1,
wherein the solvent is dipropylene glycol monomethyl ether or methyl propylene diglycol.

7. The flux according to Claim 1,
wherein the organic acid is glutaric acid.

8. The flux according to Claim 1,
wherein the amine is a propylene oxide adduct of ethylenediamine.

9. A method for applying a flux, the method comprising:
heating the flux to a temperature of 75°C to 100°C and discharging the flux through an ink-jet method to apply the flux to an electrode of a substrate,
wherein the flux used contains
5 mass% to 50 mass% of a solid solvent having a melting point of 35°C to 60°C,
50 mass% to 80 mass% of a solvent,
5 mass% to 10 mass% of an organic acid,
10 mass% to 30 mass% of an amine, and
0 mass% to 5 mass% of a halide, and
wherein the flux becomes a liquid having a high viscosity of greater than or equal to 5 Pa·s at 25°C and becomes a liquid having a low viscosity of less than or equal to 50 mPa·s at 100°C.

10. The method for applying a flux according to Claim 9,
wherein the diameter of the electrode is greater than 0 µm and less than or equal to 1,000 µm in a case where the electrode is circular, and the length of the electrode in a short direction is greater than 0 µm and less than or equal to 1,000 µm in a case where the electrode is quadrilateral.

11. The method for applying a flux according to Claim 9,
wherein the diameter of the electrode is 30 µm to 100 µm in a case where the electrode is circular, and the length of the electrode in a short direction is 30 µm to 100 µm in a case where the electrode is quadrilateral.

12. A method for mounting a solder ball, the method comprising:
heating a flux to a temperature of 75°C to 100°C and discharging the flux through an ink-jet method to apply the flux to an electrode of a substrate; and
placing a solder ball on the flux, applied to the electrode of the substrate and of which the temperature decreases to below 35°C, to fix the solder ball with the flux,
wherein the flux used contains
5 mass% to 50 mass% of a solid solvent having a melting point of 35°C to 60°C,
50 mass% to 80 mass% of a solvent,
5 mass% to 10 mass% of an organic acid,
10 mass% to 30 mass% of an amine, and
0 mass% to 5 mass% of a halide, and
wherein the flux becomes a liquid having a high viscosity of greater than or equal to 5 Pa·s at 25°C and becomes a liquid having a low viscosity of less than or equal to 50 mPa·s at 100°C.

13. The method for mounting a solder ball according to Claim 12,
wherein the diameter of the electrode is greater than 0 µm and less than or equal to 1,000 µm in a case where the electrode is circular, and the length of the electrode in a short direction is greater than 0 µm and less than or equal to 1,000 µm in a case where the electrode is quadrilateral.

14. The method for mounting a solder ball according to Claim 12,
wherein the diameter of the electrode is 30 µm to 100 µm in a case where the electrode is circular, and the length of the electrode in a short direction is 30 µm to 100 µm in a case where the electrode is quadrilateral.

15. The method for mounting a solder ball according to any one of Claims 12 to 14,
wherein the diameter of the solder ball is 1 µm to 1,000 µm.

16. The method for mounting a solder ball according to any one of Claims 12 to 14,
wherein the diameter of the solder ball is 30 µm to 100 µm.
